Europäisches Patentamt

European Patent Office

Office européen des brevets

(11) Veröffentlichungsnummer: **0 209 688 B1**

(12) **EUROPÄISCHE PATENTSCHRIFT**

(45) Veröffentlichungstag der Patentschrift: **27.02.91**

(51) Int. Cl.5: **G01R 19/15, H02P 7/295**

(21) Anmeldenummer: **86107572.9**

(22) Anmeldetag: **04.06.86**

(54) **Schaltung zur Erfassung des Stromflusses eines Triac.**

(30) Priorität: **25.06.85 DE 3522586**

(43) Veröffentlichungstag der Anmeldung:
**28.01.87 Patentblatt 87/05**

(45) Bekanntmachung des Hinweises auf die
Patenterteilung:
**27.02.91 Patentblatt 91/09**

(84) Benannte Vertragsstaaten:
**FR GB IT**

(56) Entgegenhaltungen:
**DE-A- 2 526 045**

(73) Patentinhaber: **TELEFUNKEN electronic GmbH
Theresienstrasse 2
D-7100 Heilbronn(DE)**

(72) Erfinder: **Nutz, Karl-Diether
Blumenstrasse 33
D-7101 Oedheim(DE)**
Erfinder: **Frank, Willy
Im Rappenweg 5
D-7129 Ilsfeld(DE)**

(74) Vertreter: **Maute, Hans-Jürgen, Dipl.-Ing.
TELEFUNKEN electronic GmbH Theresienstrasse 2
D-7100 Heilbronn(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Bei der Steuerung von Universalmotoren mit Hilfe einer Phasenanschnittsteuerung sind Strom und Spannung nicht unbedingt in Phase (cos y ≠ 1). Würde einem Triac während einer Nacheilphase und damit zu einem Zeitpunkt der Zündimpuls zugeführt werden, in dem der Triac noch Strom führt, würde es zu Lücken des Laststromes kommen. Um diesen unerwünschten Effekt zu vermeiden, wird bei Phasenanschnittsteuerungen ein Stromdetektor eingesetzt, der feststellt, ob der Triac einen Stromfluß aufweist oder nicht.

Zur Erfassung des Stromflusses eines Triac wird bisher die Spannung über dem als Leistungsschalter vorgesehenen Triac verwendet, d. h. die Spannung zwischen H1 und H2. Diese bekannte Stromflußabfrage hat jedoch den Nachteil, daß zur Abfrage der Spannung über dem Triac ein separater Schaltungseingang und ein externer Widerstand erforderlich sind. Da Phasenanschnittsteuerungen heute bekanntlich integriert werden, bedeuten ein gesonderter Schaltungseingang und ein externer Widerstand einen zusätzlichen Aufwand, der unerwünscht ist.

Aus der DE-A- 25 26 045 ist eine Schaltungsanordnung zur Bildung von Zündimpulsen für einen Wechselstromsteller bekannt, dessen Steuerstrecke an eine Ansteuerschaltung angeschlossen ist, die einen Kondensator und eine parallelgeschaltete symmetrische Schwellwertdiodenanordnung enthält. Aus der Netzwechselspannung wird eine stabilisierte Ladewechselspannung abgeleitet, die an eine Reihenschaltung eines ohmschen Widerstandes und eines Sollwertpotentiometers angeschlossen ist, an dessen Abgriff ein weiterer Kondensator geschaltet ist. Ein von der Netzwechselspannung bzw. von der stabilisierten Ladewechselspannung gesteuerter Schaltkreis verbindet den Kondensator der Ansteuerschaltung mit einer am Sollwertpotentiometer abgegriffenen Vorladespannung und mit der über einen ohmschen Widerstand geführten Ladewechselspannung als Nachladespannung.

Der Erfindung liegt die Aufgabe zugrunde, eine Schaltung zur Erfassung des Stromflusses eines Triac und damit einen Stromdetektor anzugeben, der ohne peripheren Aufwand voll integrierbar ist. Diese Aufgabe wird bei einer Schaltung zur Erfassung des Stromflusses eines Triac nach der Erfindung dadurch gelöst, daß sie mit nur einer Betriebsspannung arbeitet, daß der eine Pol dieser Betriebsspannung gleichzeitig Bezugspunkt des Triac ist, daß sie zur Erfassung des Stromflusses des Triac die um den Bezugspunkt schwankende Gatespannung des Triac heranzieht, daß sie die Gatespannung des Triac in den Bereich der Betriebsspannung der Erfassungsschaltung transformiert und daß sie in Abhängigkeit von der Gatespannung eine digitale Information erzeugt, die eine Aussage darüber liefert, ob im Triac ein Laststrom fließt oder nicht.

Die Erfindung wird im folgenden an Ausführungsbeispielen erläutert.

Nach der Erfindung wird die für die Stromflußabfrage und damit für den Stromdetektor erforderliche Information aus dem Signal am Steuerausgang der integrierten Schaltung entnommen, welches gleichzeitig die Steuerspannung am Gate des Triac ist.

Die Figur 1 zeigt den Verlauf der Netzspannung $u_{Netz}$, des Laststromes $i_{Last}$ des Triac sowie die Gatespannung $u_{Gate}$ am Gate des Triac.

Die Figur 2 zeigt eine Schaltung zur Erfassung des Stromflusses eines Triac.

Die Figur 3 zeigt eine Schaltung zur Erfassung des Stromflusses eines Triac, die auch bei relativ kleinen Gatespannungen einen Laststrom anzeigt.

Die Figur 4 zeigt eine positive und eine negative Halbwelle in symbolisierter Form und die Figur 5 die dazugehörigen logischen Werte, die von der Schaltung nach der Erfindung in Abhängigkeit von der Gatespannung des Triac geliefert werden.

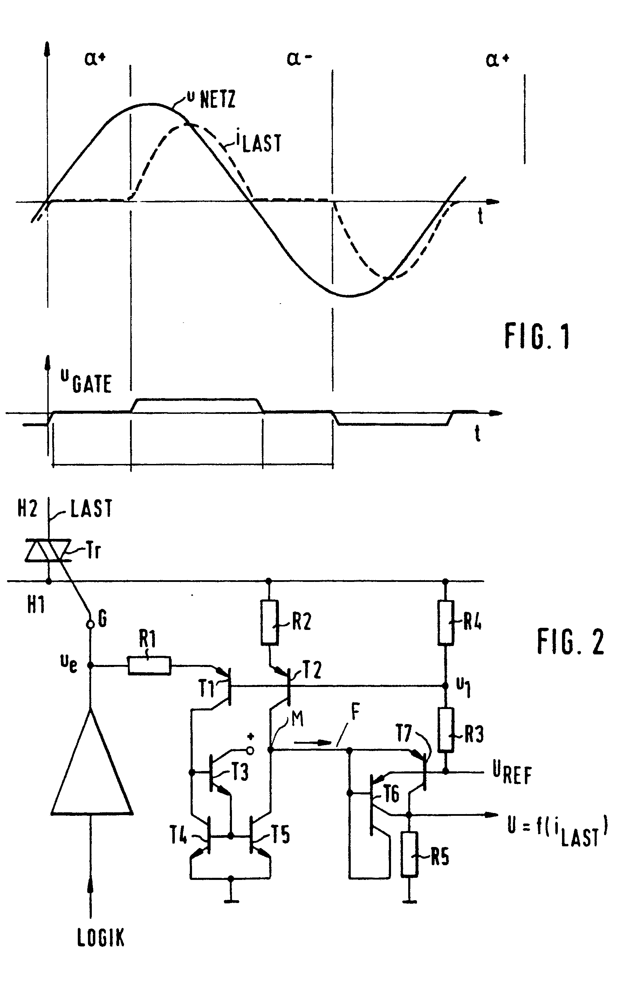

Wie der Figur 1 zu entnehmen ist, ist die Gatespannung $u_{Gate}$ Null, wenn der Triac stromlos ist, während umgekehrt die Gatespannung von Null verschieden ist, wenn der Triac stromführend ist.

Da die Gatespannung eines Triac während der stromführenden Phase je nach Laststrom und Temperatur zwischen 3 V und 400 mV liegen kann, muß die Erfassungsschaltung (Stromdetektor) als Fensterdiskriminator mit etwa ± 300 mV um den Triac-Bezugspunkt arbeiten. Die Figur 2 zeigt als Ausführungsbeispiel eine Schaltung zur Erfassung des Stromflusses eines Triac, die diese Bedingung sowie die triacspezifische Forderung nach negativer Ansteuerung erfüllt. Außerdem kommt die Schaltung der Figur 2 mit der kostengünstigen Einfach-Stromversorgung mit nur einer Betriebsspannung aus.

Bei der Schaltung der Figur 2 wird die Spannung $u_e$ am Gate-Anschluß des Triac Tr abgenommen. Der Kollektorstrom des Transistor T1 ist von der Spannung $U_e$ am Gate des Triac abhängig. Der Transistor T2 dient zur Erzeugung des Referenzstromes. Der Referenztransistor T2 erhält seine Basisspannung mittels eines Spannungsteilers, der aus den Widerständen R3 und R4 besteht und der zwischen die Referenzspannung $U_{ref}$ und die Bezugsspannung geschaltet ist. Dabei ist der Teilerpunkt des Spannungsteilers mit der Basis des Referenztransistors T2 verbunden. Zwischen die Bezugsspannung und den Emitter des Transistors T2 ist ein Widerstand R2 geschaltet. Der Referenzstrom ist der Kollektorstrom des Referenztransistors T2.

Die Basis des Transistors T1, der einen von der Gatespannung des Triac abhängigen Strom erzeugt, ist ebenso wie die Basis des Transistors T2 mit dem Teilerpunkt des Spannungsteilers (R3, R4) verbunden. Zwischen den Emitter des Transistors T1 und den Triac Tr ist ein Widerstand R1 geschaltet. Die beiden Widerstände R1 und R2 sollen möglichst die gleichen elektrischen Eigenschaften und damit auch den gleichen Widerstandswert aufweisen. Dies erreicht man in einfacher Weise dadurch, daß beide Widerstände zusammen mit der übrigen Schaltung in einem gemeinsamen Halbleiterchip integriert werden.

Haben neben den Widerständen R1 und R2 auch die beiden Transistoren T1 und T2 die gleichen elektrischen Eigenschaften (ebenfalls durch gemeinsame Integration erreichbar), so sind für den Fall, daß der Triac Tr keinen Laststrom führt, der Kollektorstrom durch den Transistor T1 und der Kollektorstrom durch den Transistor T2 (Referenzstrom) absolut gesehen gleich groß.

Der Kollektorstrom des Transistors T1 wird durch eine Stromspiegelschaltung invertiert, die aus den Transistoren T3, T4 und T5 besteht. Der invertierte Kollektorstrom des Transistors T1 und der Kollektorstrom (Referenzstrom) des Transistors T2 fließen über den Punkt M in eine gemeinsame Leitung F. Da beide Ströme gleich groß sind, heben sich beide Ströme in der Leitung F dann auf und ergeben dann einen Differenzstrom $I_{dif}$ Null, wenn der Laststrom des Triac Tr Null ist. Fließt dagegen Laststrom durch den Triac Tr, so ist die Gatespannung $\neq$ 0 und der Kollektorstrom des Transistors T1 ungleich dem Referenzstrom $I_{ref}$. In der Leitung F fließt in diesem Fall ein Strom, der proportional zur Gatespannung $u_e$ des Triac ist.

Der in der Leitung F fließende Differenzstrom $I_{dif}$ wird durch einen Stromspiegel T6 und den in Basisschaltung betriebenen Transistor T7 gleichgerichtet. Beim Transistor T6 ist ein Kollektor mit der Basis verbunden. Im Ausführungsbeispiel der Figur 2 läßt der Transistor T7 die positive Halbwelle und der Transistor T6 die negative Halbwelle des Differenzstromes $I_{dif}$ durch. Der durch T6, T7 gleichgerichtete Differenzstrom erzeugt am Widerstand R5 eine Spannung U, die eine Funktion der Gatespannung des Triac Tr und damit ein Indikator für einen Stromfluß im Triac ist.

Die Gatespannung eines Triac kann sehr kleine Werte annehmen, und zwar dann , wenn die Netzspannung zu Beginn einer Halbwelle noch klein ist, wenn die Netzspannung am Ende einer Halbwelle der Netzspannung wieder klein wird oder wenn die an den Triac angeschaltete Last sehr klein ist. Letzteres ist der Fall, wenn der Laststrom klein ist. Um auch bei kleinen Gatespannungen die gewünschte Information (logische 1 oder logische 0) über den Laststromfluß des Triac zu erhalten, wird eine empfindliche Schaltung benötigt, die auch bei kleinen Gatespannungen die gewünschte Information liefert und eine kleine Schwelle aufweist. Dabei ist noch zu berücksichtigen, daß die Gatespannung des Triac eine Wechselgröße ist, die um den Bezugspunkt des Triac schwankt, der bei der Schaltung der Erfindung gleichzeitig der Bezugspunkt (Pluspol) der Erfassungschaltung ist. Es bereitet nämlich Schwierigkeiten, Spannungen zu detektieren, die, wie im vorliegenden Fall, über der Bezugsspannung liegen und positiver als die Bezugsspannung (Pluspol) sind. Positivere Spannungswerte als die Bezugsspannung (Pluspol) treten im vorliegenden Fall dann auf, wenn der Triac in der positiven Halbwelle der Netzspannung Strom führt.

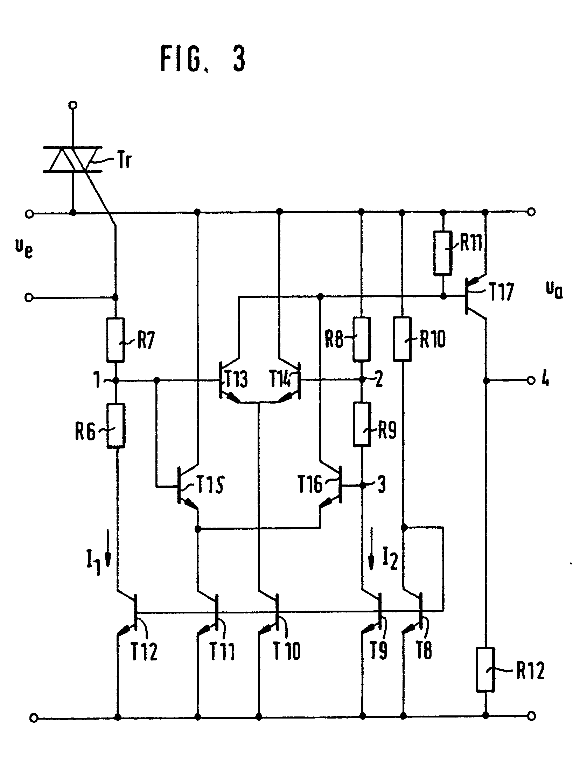

Die Figur 3 zeigt eine besonders empfindliche Erfassungsschaltung nach der Erfindung, die auch bei relativ kleinen Gatespannungen einen vorhandenen Laststromfluß anzeigt. Die Erfassungsschaltung der Figur 3 weist im wesentlichen zwei Spannungsteiler (R6, R7 und R8, R9), sowie zwei Komparatoren (T13, T14 und T15, T16) auf. Die beiden Spannungsteiler werden von gleichen Konstantströmen durchflossen und ihre Widerstände weisen gleiche Gesamtwiderstandswerte auf.

Zur Einstellung der Konstantströme dient bei der Schaltung der Figur 3 die Reihenschaltung des Widerstandes R10 mit dem als Diode geschalteten Transistor T8. Ist der Transistor T8 nicht leitend, so fließt der gesamte Strom in die Basis des Transistors T8. Dadurch werden die Basis des Transistors T8 und die mit der Basis des Transistors T8 verbundenen Basen der Transistoren T9, T10, T11 und T12 aufgesteuert und als Folge davon werden die Transistoren T8, T9, T10, T11 und T12 leitend. Da die Basen der Transistoren T8 bis T12 miteinander verbunden sind und auch die Emitter dieser Transistoren untereinander verbunden sind, haben die Transistoren T8 bis T12 alle das gleiche $U_{be}$ und liefern deshalb auch alle den gleichen Kollektorstrom. Die Transistoren T9 bis T12 bilden deshalb in Verbindung mit dem Transistor T8 eine Mehrfachkonstantstromquelle. Der Transistor T8 regelt die Basisspannung aller Transistoren T9 bis T10 auf denjenigen Wert, der erforderlich ist, um den gewünschten Konstantstrom für die einzelnen Zweige der Schaltung zu liefern.

Da die Gatespannung des Triac um den Bezugspunkt der Schaltung schwankt, kann man mit ihr unmittelbar nichts anfangen, sondern es ist erforderlich, sie in einen Bereich zu transformieren, der innerhalb des Bereichs der Betriebsspannung der Schaltung liegt.

An den Widerständen R6 und R7 des ersten Spannungsteilers entsteht ein Spannungsabfall, der immer konstant bleibt, weil der über diese Widerstände fließende Strom konstant bleibt. Dieser Spannung wird die Gatespannung des Triac überlagert. Die Spannung am Punkt 1 ergibt sich aus der Summe der Spannung am Widerstand R6 ± Gatespannung.

Der aus den Widerständen R8 und R9 bestehende Spannungsteiler bildet einen Referenzzweig und wirkt somit als Referenzteiler, der zur Einstellung der Schaltpunkte (+ 0,25 V und - 0,25 V) der beiden Komparatoren dient. Die eine der beiden Referenzspannungen liegt am Punkt 2 und die andere Referenzspannung liegt am Punkt 3. Die Spannung am Punkt 3 ist um 0,5 V negativer als die Spannung am Punkt 2. Damit die Schaltung symmetrisch arbeitet, ist R7 so dimensioniert, daß bei $U_e = 0$ die Spannung an Punkt 1 exakt in der Mitte zwischen den Spannungswerten an den Punkten 2 und 3 liegt.

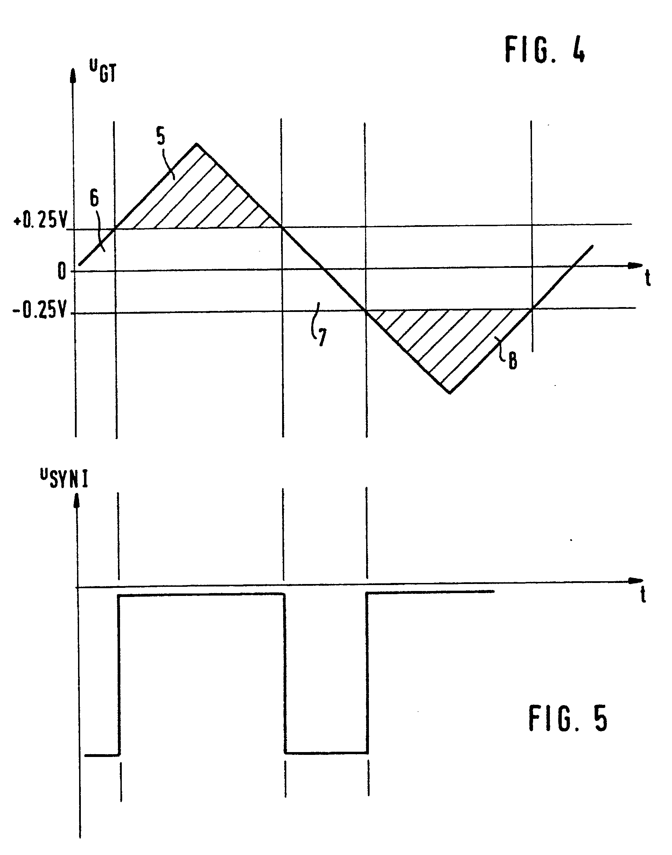

Ist die Spannung am Punkt 1 positiver als die Spannung am Punkt 2 - dies ist der Fall, wenn in der positiven Halbwelle ein Laststrom im Triac fließt und damit die Gatespannung positiv ist - dann wird der Transistor T17 leitend und die Ausgangsspannung der Schaltung am Punkt 4 entspricht einer logischen 1, die gleichbedeutend mit einem Laststronfluß des Triac ist, In diesem Fall befindet man sich im gestrichelten Bereich 5 der Figur 4, die Zeigt, wann der Triac ein- bzw. ausgeschaltet ist bzw. wann der Triac Laststrom führt und wann nicht. Auf der Ordinate der Figur 4 sind die beiden Schwellenpunkte + 0,25 V und - 0,25 V eingetragen. Die Gatespannung ist durch eine dreieckförmige positive Halbwelle und durch eine dreieckförmige negative Halbwelle symbolisiert. In der positiven Halbwelle wird durch die Schaltung der Figur 3 ein Laststromfluß in Gestalt einer am Ausgang erscheinenden logischen 1 angezeigt, wenn die Gatespannung des Triac in der positiven Halbwelle die Schaltspannung + 0,25 V übersteigt. Dies ist im gestrichelten Bereich 5 der Fall.

Der Triac ist außerdem eingeschaltet (auch hier wird ein Laststromfluß angezeigt), wenn die Gatespannung des Triac in der negativen Halbwelle den Schaltpunkt - 0,25 V unterschreitet. Wie die Figur 5 zeigt, liefert die Schaltung der Figur 1 eine logische 0 in den zwischen den Schaltpunkten + 0,25 V und - 0,25 V liegenden Bereichen 6 und 7, während die Schaltung der Figur 3 eine logische 1 in den gestrichelten Bereichen 5 und 8 liefert, die außerhalb der Schaltpunkte + 0,25 V und - 0,25 V liegen.

Geht der Laststrom des Triac gegen Null, dann wird die Spannung am Punkt 1 negativer als am Punkt 2. In diesem Fall ist der Transistor T17 ausgeschaltet und durch den Widerstand R9 wird in diesem Fall der Zustand logisch 0 am Ausgang 4 der Schaltung erzeugt.

Die obigen Ausführungen beziehen sich auf die Verhältnisse in der positiven Halbwelle der Netzspannung. Im folgenden werden die Verhältnisse in der negativen Halbwelle der Netzspannung beschrieben. Während der aus den Transistoren T13 und T14 bestehende erste Komparator für die positive Halbwelle der Netzspannung zuständig ist, ist der aus den Transistoren T15 und T16 bestehende zweite Komparator für die negative Halbwelle der Netzspannung zuständig. Bei Laststromfluß in der negativen Halbwelle der Netzspannung entsteht am Gate des Triac eine negative Spannung. Diese negative Gatespannung wird der Spannung am Punkt 1 überlagert, wodurch die Spannung am Punkt 3 positiver als die Spannung am Punkt 1 wird. Der Transistor T16 steuert in diesem Fall den Transistor T17 an, wodurch am Punkt 4 eine logische 1 erzeugt wird.

Da die Emitter der Komparatortransistoren miteinander verbunden sind, leitet bei den Komparatoren nur derjenige der beiden Komparatortransistoren, dessen Basis positiver ist als die Basis des anderen Transistors. Wenn beim zweiten Komparator der Transistor T15 leitend ist, so hat dies keine Auswirkung auf den Ausgang 4. Ist dagegen der Transistor T16 leitend, so hat dies eine Auswirkung auf den Ausgang 4 und zwar wird in diesem Fall am Ausgang 4 eine logische 1 erzeugt, weil der Transistor T16 den Transistor T17 ansteuert.

Bewegt man sich entlang der Dreieckskurve der Figur 4 beispielsweise von rechts unten nach links oben, dann ist im unteren Bereich der Transistor T17 leitend, weil der Punkt 3 der Schaltung eine positivere Spannung hat als der Punkt 1. Der Punkt 4 der Schaltung zeigt in diesem Bereich eine logische 1. Durchläuft man von unten kommend den Schaltpunkt - 0,25 V, dann wechselt der Stromfluß, d. h. der Konstantstrom, der vom Transistor T11 bereitgestellt wird, wird vom Transistor T15 übernommen, weil der Punkt 1 positiver ist als der Punkt 3. Damit wird auch der Transistor T17 hochohmig und damit nicht leitend, so daß der Punkt 4 den Zustand logisch 0 annimmt. In den genannten Spannungsbereichen leitet der Transistor T14 des ersten Komparators, weil der Punkt 2 positiver als der Punkt 1 ist. In diesem Fall hat der vom Transistor T10 bereitgestellte Konstantstrom keine Auswirkung auf den Transistor T17 und damit auf den Punkt 4.

Fährt man weiter in den Bereich der positiven Halbwelle der Gatespannung bis zum zweiten Schaltpunkt (+ 0,25 V) was dann der Fall ist, wenn der Punkt 1 positiver als der Punkt 2 wird, so wird der Transistor T17 über den Transistor T13 angesteuert.

**Ansprüche**

1. Schaltung zur Erfassung des Stromflusses eines Triac, dadurch gekennzeichnet, daß sie mit nur einer Betriebsspannung arbeitet, daß der eine Pol dieser Betriebsspannung gleichzeitig Bezugspunkt des Triac ist, daß sie zur Erfassung des Stromflusses des Triac die um den Bezugspunkt schwankende Gatespannung des Triac heranzieht, daß sie die Gatespannung des Triac in den Bereich der Betriebsspannung der Erfassungsschaltung transformiert und daß sie in Abhängigkeit von der Gatespannung eine digitale Information erzeugt, die eine Aussage darüber liefert, ob im Triac ein Laststrom fließt oder nicht.

2. Schaltung nach Anspruch 1, dadurch gekennzeichnet, daß die digitale Information unabhängig von der Polarität der Gatespannung ist.

3. Schaltung nach Anspruch 1 oder 2, dadurch gekennzeichnet daß sie einen Referenzstrom sowie einen Strom erzeugt, der von der Gatespannung des Triac abhängig ist, daß sie einen Differenzstrom erzeugt, der durch Differenzbildung dieser beiden Ströme gebildet wird, und daß der Differenzstrom gleichgerichtet wird.

4. Schaltung nach einem der Ansprüche 1 bis 3, dadurch gekennzeichnet, daß sie einen von der Gatespannung abhängigen Strom erzeugt, der für den Fall, daß die Gatespannung des Triac Null ist, absolut gesehen möglichst gleich dem Referenzstrom ist.

5. Schaltung nach einem der Ansprüche 1 bis 4, dadurch gekennzeichnet, daß zur Gleichrichtung des Differenzstromes eine Stromspiegelschaltung vorgesehen ist, deren Transistor die eine Halbwelle und deren als Diode geschalteter Transistor die andere Halbwelle des Differenzstromes durchläßt.

6. Schaltung nach einem der Ansprüche 1 bis 5, dadurch gekennzeichnet, daß zur Erzeugung des Referenzstromes ein Transistor und ein Spannungsteiler vorgesehen sind, der an einer Referenzspannung liegt und dessen Teilerpunkt mit der Basis des Referenztransistors verbunden ist.

7. Schaltung nach einem der Ansprüche 1 bis 6, dadurch gekennzeichnet, daß zwischen den Bezugspunkt und den Emitter des Referenztransistors ein Widerstand geschaltet ist.

8. Schaltung nach einem der Ansprüche 1 bis 7, dadurch gekennzeichnet, daß zur Erzeugung des von der Gatespannung des Triac abhängigen Stromes ein Transistor vorgesehen ist, dessen Basis mit dem Teilerpunkt des Spannungsteilers und dessen Emitter über einen Widerstand mit dem Gate des Triac verbunden ist.

9. Schaltung nach einem der Ansprüche 1 bis 8, dadurch gekennzeichnet, daß der zwischen den Bezugspunkt und den Emitter des Referenztransistors geschaltete Widerstand und der Widerstand, der zwischen den Triac und den Emitter des den gateabhängigen Strom erzeugenden Transistors geschaltet ist, den gleichen Widerstandswert aufweisen

10. Schaltung nach einem der Ansprüche 1 bis 9, dadurch gekennzeichnet, daß der von der Gatespannung des Triac abhängige Strom invertiert wird und daß zum Invertieren dieses Stromes eine Stromspiegelschaltung vorgesehen ist.

11. Schaltung nach Anspruch 1 und 2, dadurch gekennzeichnet, daß sie zwei Spannungsteiler, die jeweils von einer Konstantstromquelle gespeist werden, sowie zwei Komparatoren mit jeweils zwei Transistoren aufweist.

12. Schaltung nach Anspruch 11, dadurch gekennzeichnet, daß die Widerstände der beiden Spannungsteiler die gleichen Gesamtwiderstandswerte aufweisen.

13. Schaltung nach Anspruch 11 oder 12, dadurch gekennzeichnet, daß als Konstantstromquellen Transistoren vorgesehen sind, deren Basen miteinander verbunden sind.

14. Schaltung nach einem der Ansprüche 11 bis 13, dadurch gekennzeichnet, daß zur Ansteuerung der Basen der Konstantstromquellen ein Transistor vorgesehen ist, dessen Kollektor über einen Widerstand mit der Bezugsspannung sowie mit seiner Basis verbunden ist.

15. Schaltung nach einem der Ansprüche 11 bis 14, dadurch gekennzeichnet, daß der eine Spannungsteiler zwischen eine Konstantstromquelle und die Bezugsspannung geschaltet ist.

16. Schaltung nach einem der Ansprüche 11 bis 15, dadurch gekennzeichnet, daß der andere Spannungsteiler zwischen eine Konstantstromquelle und einen Punkt geschaltet ist, an den die Gatespannung des Triac angelegt wird.

17. Schaltung nach einem der Ansprüche 11 bis 16, dadurch gekennzeichnet, daß die Konstantstromquellen-Transistoren die gleichen elektrischen Eigenschaften haben.

18. Schaltung nach einem der Ansprüche 11 bis 17, dadurch gekennzeichnet, daß die Emitter der Komparatortransistoren miteinander verbunden sind.

19. Schaltung nach einem der Ansprüche 11 bis 18, dadurch gekennzeichnet, daß die Emitter-Kollektorstrecke jeweils eines Komparatortransistors zwischen eine Konstantquelle und die Bezugsspannung geschaltet ist und daß die Emitter-Kollektorstrecke des anderen Komparatortransistors jeweils zwischen eine Konstantstromquelle und die Basis eines Transistors geschaltet ist, dessen Emitter-Kollektorstrecke den Ausgang der Schaltung bildet.

**Claims**

1. A circuit for detecting the current flow of a triac, characterised in that it operates with only one operating voltage, that one pole of this operating voltage is at the same time the datum point of the triac, that the circuit uses the gate voltage of the triac, which fluctuates about the datum point, for detecting the current flow in the triac, that the circuit transforms the gate voltage of the triac into the region of the operating voltage of the detection circuit and that the circuit produces a digital information signal depending on the gate voltage, and indicating whether a load current is flowing in the triac or not

2. A circuit according to claim 1, characterised in that the digital information signal is independent of the polarity of the gate voltage

3. A circuit according to claim 1 or 2, characterised in that the circuit produces a reference current and a current which depends on the gate voltage of the triac, that the circuit produces a difference current which is formed by forming the difference between these two currents, and that the difference current is rectified

4. A circuit according to any one of claims 1 to 3, characterised in that the circuit produces a current which depends on the gate voltage and which, in the case where the gate voltage of the triac is zero, has an absolute value as far as possible equal to the reference current

5. A circuit according to any one of claims 1 to 4, **characterized in that** a current mirror circuit is provided for rectifying the difference current, its transistor allowing the passage of one half wave and its transistor connected as a diode allowing the passage of the other half wave of the difference current.

6. A circuit according to any one of claims 1 to 5, **characterized in that** for producing the reference current, there are provided a transistor and a voltage divider, which is at a reference voltage and whose divider point is connected to the base of the reference transistor.

7. A circuit according to any one of claims 1 to 6, **characterised in that** a resistor is connected between the datum point and the emitter of the reference transistor.

8. A circuit according to any one of claims 1 to 7, **characterized in that** a transistor is provided for producing the current which depends on the gate voltage of the triac, its base being connected to the divider point of the voltage divider and its emitter being connected via a resistor to the gate of the triac.

9. A circuit according to any one of claims 1 to 8, **characterized in that** the resistor connected between the datum point and the emitter of the reference transistor, and the resistor which is connected between the triac and the emitter of the transistor which produces the gate-dependent current, have the same resistance value.

10. A circuit according to any one of claims 1 to 9, **characterized in that** the current which is dependent on the gate voltage of the triac is inverted and that a current mirror circuit is provided for inverting this current.

11. A circuit according to claims 1 and 2, **characterized in that** the circuit has two voltage dividers, which are each fed by. a constant current source, and has two comparators each having two transistors.

12. A circuit according to claim 11, **characterized in that** the resistors of the two voltage dividers have the same total resistance values.

13. A circuit according to claim 11 or 12, **characterized in that** transistors are provided as constant current sources, their bases being connected together.

14. A circuit according to any one of claims 11 to 13, **characterized in that** a transistor is provided for driving the bases of the constant current sources, its collector being connected via a resistor to the datum voltage and to its base.

15. A circuit according to any one of claims 11 to 14, **characterized in that** one voltage divider is connected between a constant current source and the datum voltage.

16. A circuit according to any one of claims 11 to 15, **characterized in that** the other voltage divider is connected between a constant current source and a point at which the gate voltage of the triac is applied.

17. A circuit according to any one of claims 11 to 16, **characterized in that** the constant current source transistors have the same electrical properties.

18. A circuit according to any one of claims 11 to 17, **characterized in that** the emitters of the comparator transistors are connected together.

19. A circuit according to any one of claims 11 - to 18, **characterized in that** the emitter/collector path of a comparator transistor is connected in each case between a constant source and the datum voltage and that the emitter/collector path of the other comparator transistor is connected in each case between a constant current source and the base of a transistor, the emitter/collector path of which forms the output of the circuit.

## Revendications

1. Dispositif pour déceler la conduction de courant d'un triac, caractérisé par le fait qu'il ne travaille qu'avec une tension de fonctionnement, par le fait que le premier pôle de cette tension de fonctionnement est en même temps point de référence du triac, par le fait que, pour déceler la conduction de courant du triac, il recourt à la tension de grille du triac fluctuant autour du point de référence, par le fait qu'il transforme la tension de grille du triac dans le domaine de la tension de fonctionnement du circuit pour déceler, et par le fait qu'il engendre, en fonction de la tension de grille, une information numérique qui fournit un message indiquant si un courant de charge s'écoule ou ne s'écoule pas dans le triac.

2. Circuit selon revendication 1, caractérisé par le fait que l'information numérique est indépendante de la polarité de la tension de grille.

3. Circuit selon revendication 1 ou 2, caractérisé par le fait qu'il engendre un courant de référence ainsi qu'un courant qui dépend de la tension de grille du triac, par le fait qu'il engendre un courant de différence qui est formé par différenciation de ces deux courants, et par le fait que le courant de différence est redressé.

4. Circuit selon l'une des revendications 1 à 3, caractérisé par le fait qu'il engendre un courant dépendant de la tension de grille, lequel, pour le cas où la tension de grille du triac est nulle, est autant que possible égal au courant de référence, considéré de manière absolue.

5. Circuit selon l'une des revendications 1 à 4, caractérisé par le fait que, pour le redressement du courant de différence, il est prévu un circuit miroir de courant, dont un transistor laisse passer une alternance et l'autre transistor monté en tant que diode laisse passer l'autre alternance du courant de différence.

6. Circuit selon l'une des revendications 1 à 5, caractérisé par le fait que, pour engendrer le courant de référence, il est prévu un transistor et un diviseur de tension qui est appliqué à une tension de référence et dont le point de division est relié à la base du transistor de référence.

7. Circuit selon l'une des revendications 1 à 6, caractérisé par le fait qu'une résistance est branchée entre le point de référence et l'émetteur du transistor de référence.

8. Circuit selon l'une des revendications 1 à 7, caractérisé par le fait qu'il est prévu, pour engendrer le courant dépendant de la tension de grille du triac, un transistor dont la base est reliée au point de division du diviseur de tension et dont l'émetteur est relié à la grille du triac par l'intermédiaire d'une résistance.

9. Circuit selon l'une des revendications 1 à 8, caractérisé par le fait que la résistance branchée entre le point de référence et l'émetteur du transistor de référence, et la résistance qui est branchée entre le triac et l'émetteur du transistor engendrant le courant dépendant de la grille présentent la même valeur de résistance.

10. Circuit selon l'une des revendications 1 à 9, caractérisé par le fait que le courant dépendant de la tension de grille du triac est inversé et par le fait que, pour l'inversion de ce courant, il est prévu un circuit miroir de courant.

11.  Circuit selon revendications 1 et 2, caractérisé par le fait qu'il présente deux diviseurs de tension qui sont alimentés chacun par une source de courant constant, et présente deux comparateurs avec chacun deux transistors.

12.  Circuit selon revendication 11, caractérisé par le fait que les résistances des deux diviseurs de tension présentent les mêmes valeurs de résistance totale.

13.  Circuit selon revendication 11 ou 12, caractérisé par le fait que des transistors dont les bases sont reliées l'une à l'autre. sont prévus en tant que sources de courant constant.

14.  Circuit selon l'une des revendications 11 à 13, caractérisé par le fait qu'il est prévu, pour la commande des bases des sources de courant constant, un transistor dont le collecteur est relié via une résistance à la tension de référence ainsi qu'à sa base.

15.  Circuit selon l'une des revendications 11 à 14, caractérisé par le fait que le Premier diviseur de tension est branché entre une source de courant constant et la tension de référence.

16.  Circuit selon l'une des revendications 11 à 15, caractérisé par le fait que l'autre diviseur de tension est branché entre une source de courant constant et un point auquel est appliquée la tension de grille du triac.

17.  Circuit selon l'une des revendications 11 à 16, caractérisé par le fait que les transistors des sources de courant constant ont les mêmes caractéristiques électriques.

18.  Circuit selon l'une des revendications 11 à 17, caractérisé par le fait que les émetteurs des transistors des comparateurs sont mutuellement reliés.

19.  Circuit selon l'une des revendications 11 à 18, caractérisé par le fait que le trajet émetteur-collecteur d'un transistor de comparateur est branché à chaque fois entre une source de courant constant et la tension de référence, et par le fait que le trajet émetteur-collecteur de l'autre transistor de comparateur est branché à chaque fais entre une source de courant constant et la base d'un transistor dont le trajet émetteur-collecteur forme la sortie du circuit.

FIG. 1

FIG. 2

# FIG. 3

FIG. 4

FIG. 5